# EUROPÄISCHE PATENTANMELDUNG

(11) **EP 1 890 393 A1**
(43) Veröffentlichungstag der Anmeldung: **20.02.2008**
(21) Anmeldenummer: 07013422.6
(22) Anmeldetag: 10.07.2007
(51) Int. Cl.: H04B 5/00, H01F 19/08, H03K 17/723

(54) **Verfahren zur Impulsübertragung und Schaltungsanordnung zur Durchführung dieses Verfahrens**

(30) Priorität: 16.08.2006 DE 102006038154
(71) Anmelder: SEMIKRON Elektronik GmbH & Co. KG, 90431 Nürnberg (DE)
(72) Erfinder: Katzenberger, Gunter, 91058 Erlangen (DE); Bode, Rüdiger, 90763 Fürth (DE); Katzenberger, Günther, 97084 Würzburg (DE); Hofmair, Markus, 91154 Roth (DE); Mühlhöfer, Alexander, 90522 Oberasbach (DE)

(57) **Zusammenfassung**

Es wird ein Verfahren zur impulsübertragung (10), insbesondere zur Datenübertragung zwischen einer galvanisch getrennten Primär- und Sekundärseite (12 und 14) über einen Impulsübertrager (10), sowie eine Schaltungsanordnung zur Durchführung dieses Verfahrens beschrieben, wobei die Wicklung der Primärseite (12) des Impulsübertragers (10) - je nach der Richtung der zu übertragenden Impulse - hart auf eine positive oder negative Spannung angehoben wird. Das überträgt sich auf die Sekundärseite (14), wobei der Strom durch die Hauptinduktivität des Impulsübertragers (10) dreieckförmig ansteigt. Nach der gewünschten Impulsdauer wird die Primärseite (12) hart kurzgeschlossen.

## Beschreibung

Die Erfindung betrifft ein Verfahren zur Impulsübertragung, insbesondere zur Datenübertragung zwischen einer galvanisch getrennten Primär- und Sekundärseite über einen Impulsübertrager, und eine Schaltungsanordnung zur Durchführung dieses Verfahrens.

Nach dem Stand der Technik erfolgt die Datenübertragung zwischen der Primärseite und der Sekundärseite z.B. eines Gatetreibers in der Leistungselektronik normalerweise über einen Impulsübertrager. Um ein Signal von der Primärseite an die Sekundärseite des Treibers zu übertragen, wird der Eingangs-Spannungspegel abrupt geändert. Dabei wandelt ein primärseitiger Impulskondensator diese abrupte Spannungsänderung in einen Impuls um, der durch den Impulsübertrager zur Sekundärseite übertragen wird.

Ein Fehlersignal kann in die umgekehrte Richtung über denselben Impulsübertrager übertragen werden, indem von der Sekundärseite ein kurzer Impuls in die Sekundärwicklung des Impulsübertragers eingekoppelt wird, der dann wiederum auf der Primärseite detektiert werden kann.

Diese bekannte Schaltungsanordnung mit Impulsübertrager weist die folgenden Mängel auf:
Der Impulskondensator bildet mit dem Impulsübertrager einen gedämpften Schwingkreis, so dass auf den jeweiligen Impuls mindestens ein Überschwinger (= "backswing") folgt. Um diesen mindestens einen Überschwinger klein genug zu hatten-um ihn auch in einer gestörten Umgebung, d.h. durch EMV-Störungen, Toleranzen o. dgl., von einem regulären Impuls unterscheiden zu können-, ist die Einhaltung enger Parameter bei allen, bei der lmpulsübertragung verwendeten, Bauteilen bzw. ein zusätzlicher Bauteileaufwand erforderlich. Daraus resultieren nicht zu vernachlässigende Kosten.

Je nach der für den Einschaltimpuls gewählten Polarität kann ein Rücksignal über denselben Impulsübertrager erst dann sicher übertragen werden, wenn der Ein- oder Ausschalt-Impuls einschließlich den aus diesen resultierenden Überschwingungen sicher abgeklungen sind.

Die auf der Sekundärseite des Impulsübertragers gemessene Impulshöhe ist bspw. stark von den Bauteil-Toleranzen abhängig; die Schwankungen der Bauteilparameter betragen bei den bekannten Pulsübertragern - je nach Parameter - oftmals zwischen ± 10 und ± 30%.

Das Zeitintegral über die Spannung am Impulsübertrager ist bei der Übertragung eines Impulses mit einer gewissen Stromstärke und Dauer am sekundärseitigen Empfänger hoch. Eine gewisse Stromstärke ist aus Gründen der Störsicherheit erforderlich. Aus diesem hohen Zeit-Integral über die Spannung resultiert im Kern des Impulsübertragers ein entsprechend starkes Magnetfeld. Das bedingt einen entsprechend groß dimensionierten Übertragerkern, um eine Sättigung des Impulsübertragers und eine Vergrößerung der mit relativ hohen Toleranzen versehenen Kernverluste zu vermeiden. Es ist also für die vorgeschlagene Anwendung bislang die Einhaltung engerer Bauteiltoleranzen notwendig, was ebenfalls die Kosten beeinflusst.

Der Erfindung liegt die Aufgabe zugrunde, ein Verfahren zur Impulsübertragung der eingangs genannten Art zu schaffen, mit dem es auf einfache Weise möglich ist, die genannten Mängel bekannter Impulsübertrager zu vermeiden, und eine Schaltungsanordnung zur Durchführung dieses Verfahrens zu schaffen.

Diese Aufgabe wird verfahrensgemäß durch die Merkmale des Anspruches 1, d.h. dadurch gelöst, dass die Wicklung der Primärseite des Impulsübertragers, je nach der Richtung der zu übertragenden Impulse, hart auf eine positive oder negative Spannung angehoben wird, was sich auf die Sekundärseite entsprechend überträgt, wobei der Strom durch die Hauptinduktivität des Impulsübertragers dreieckförmig ansteigt, und dass nach der gewünschten Impulsdauer die Primärseite hart kurzgeschlossen wird. Gegenständlich wird die der Erfindung zugrunde liegende Aufgabe durch die Merkmale des Anspruches 2, d.h. durch eine Schaltungsanordnung mit einem Impulsübertrager gelöst, wobei an der Primärseite des Impulsübertragers ein Sender zur Erzeugung positiver und/oder negativer Spannungsimpulse und mindestens ein Ohmscher Widerstand vorgesehen sind. Bevorzugte Aus-bzw. Weiterbildungen der erfindungsgemäßen Schaltungsanordnung sind in den Unteransprüchen 3 und 4 gekennzeichnet.

Die mit der Erfindung erzielten Vorteile bestehen darin, dass eine weitgehende Unabhängigkeit von Materialkonstanten gegeben ist, woraus eine Kostenreduktion resultiert, dass eine definierte, nahezu ausschließlich vom Windungsverhältnis des Impulsübertragers abhängige Impulshöhe verwirklicht wird, und dass eine hohe Übertragungssicherheit gewährleistbar ist, da Überschwinger vernachlässigbar klein sind, woraus ein hoher Abstand zwischen dem jeweiligen Signal und dem vernachlässigbar kleinen Überschwinger resultiert. Weitere Vorteile des erfindungsgemäßen Impulsübertragers bestehen darin, dass vergleichsweise kleine Übertragerkerne anwendbar sind, da das Zeit-Integral der Spannung am Übertrager reduziert ist. Desgleichen bestent die Möglichkeit zur Übertragung beliebiger Impulsmuster und/oder verschiedener Impulslängen sowie die Möglichkeit zur Ausmessung des Impulsübertragers durch das jeweilige System selbst, beispielsweise durch Senden eines langen Impulses und Ausmessung des Zeitpunktes, an dem der Übertrager in Sättigung geht. Ein weiterer Vorteil besteht darin, dass die Wartezeit zwischen dem Senden von Impulsen in einem Hin- und einem Rückkanal erheblich verringert wird, und dass die gleichzeitige Übertragung von Impulsen im Hin- und Rückkanal möglich ist.

Weitere Einzelheiten, Merkmale und Vorteile ergeben sich aus der nachfolgenden Beschreibung der Erfindung im Vergleich mit dem Stand der Technik in Verbindung mit den anlegenden Zeichnungen.

Es zeigen:
- Figur 1: ein Prinzipschaltbild eines bekannten Impulsübertragers,
- Figur 2: eine grafische Darstellung des Funktionszusammenhanges zwischen den Spannungen und der Zeit des Impulsübertragers gemäß Figur 1,
- Figur 3: eine der Figur 1 ähnliche Schaltung zur Darstellung eines erfindungsgemaßen Impulsübertragers, und
- Figur 4: eine der Figur 2 ähnliche Darstellung des Funktionszusamenhanges zwischen den Spannungen un der Zeit der Impulsübertragers gemäß Figur 3.

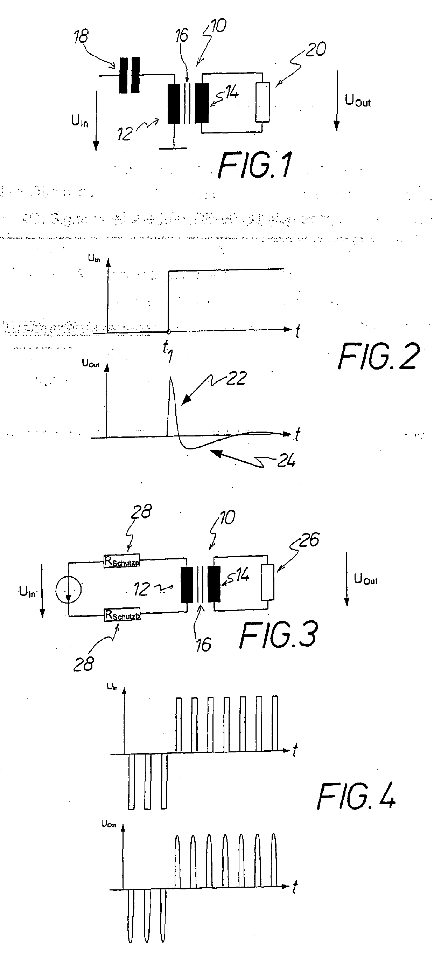

Figur 1. zeigt eine bekannte Schaltungsanordnung mit einem Impulsübertrager 10, mit seiner Primärseite 12 und seiner Sekundärseite 14, d.h. seiner Primär- und Sekundärwicklung, die an einem Übertragerkern 16 vorgesehen sind. Mit der Primärwicklung des Impulsübertragers 10 ist ein Impulskondensator 18 in Reihe geschaltet.

Die Sekundärseite 14 weist einen Dämpfungswiderstand 20 auf.

Mit Uₗₙ ist ein Eingangs-Spannungspegel und mit U_{Out} ist ein Ausgangsspannungspegel bezeichnet.

Um ein Signal an die Sekundärseite 14 zu übertragen, wird der Spannungspegel U_{In} zu einem Zeitpunkt t₁ (siehe Figur 2) abrupt geändert. Der Impulskondensator 18 wandelt diese Spannungsänderung in einen Impuls 22 (siehe Figur 2) um, der durch den Impulsübertrager 10 übertragen wird.

Der Impulskondensator 18 bildet mit dem Übertrager 10 einen durch den Dämpfungswiderstand 20 gedämpften Schwingkreis, so dass auf den Impuls 22 ein oder mehrere Überschwinger 24 (siehe Figur 2) folgen.

Um den/die Überschwinger 24 gering genug zu halten und diese Überschwinger auch in einer durch EMV-Störungen, Toleranzen oder dergleichen gestörten Umgebung von einem regulären Impuls 22 unterscheiden zu können, ist die Einhaltung enger Parameter bei allen bei der Impulsübertragung verwendeten Bauteile bzw. ein zusätzlicher Bauteileaufwand nötig.

Die auf der Sekundärseite 14 gemessene Impulshöhe ist stark von den Bauteiltoleranzen abhängig. Das Zeit-Integral über die Spannung am Impulsübertrager 10 bei der Übertragung eines Impulses 22 mit einer gewissen Stromstärke und Dauer am sekundärseitigen Empfänger ist hoch. Das zu dieser Stromstärke proportionale Magnetfeld im Übertragerkern 16 ist entsprechend groß. Dieses große Magnetfeld resultiert in der Notwendigkeit des Einsatzes eines entsprechend großen Übertragerkernes 16, um eine Sättigung des Impulsübertragers 10 und eine Erhöhung der mit hohen Toleranzen versehenen Kernverluste zu vermeiden.

Die Figuren 3 und 4 verdeutlichen das erfindungsgemäße Prinzip, wobei die Primärwicklung 12 des Impulsübertragers 10 bspw. mittels eines Logikbausteines hart auf eine positive oder negative Spannungsimpulse - je nach der gewünschten Richtung des jeweiligen Impulses - angehoben wird (siehe Figur 4). Das überträgt sich entsprechend des Windungsverhältnisses des Impulsübertragers 10 auf die Sekundärseite 14 des Impulsübertragers 10, wobei Schwankungen der Geometrie und des Sättigungsverhaltens des Impulsübertragers 10 bzw. des Übertragerkernes 16 auf die Signalspannung nur geringe Einflüsse haben. Eine Folge positiver Impulse entspricht beispielhaft einem Einschaltsignal; während eine Folge negativer Impulse einem Ausschaltsignal entspricht.

Nach der gewünschten Impulsdauer der einzelnen Impulse wird die Primärseite 12. des Impulsübertragers 10 hart kurzgeschlossen. Der Strom durch die Hauptinduktivität des Impulsübertragers 10 fließt durch den primärseitigen Kurzschluss ab und wird nur vernachlässigbar gering auf die Sekundärseite 14 übertragen. Auf der Sekundärseite 14 kommen daher bei der Übertragung von Rechteckimpulsen durch die begrenzte Bandbreite geringfügig abgerundete, jedoch definierte und einfach auszumessende Rechteckimpulse an.

Geht der Impulsübertrager 10 beispielsweise durch Materialfehler oder durch eine Fehlansteuerung in Sättigung, so steigt der Strom durch den Impulsübertrager 10 und damit auch aus dem Sender rapid an. Um das zu verhindern, d.h. zur Erhöhung der Robustheit, wird erfindungsgemäß vorgeschlagen-, dass ein Teil des Abschlusswiderstandes 26 (siehe Figur 3) auf der Primärseite 12 des Impulsübertragers 10 angeordnet wird. Das ist durch die beiden Schutzwiderstände 28 verwirklicht. Da die Ströme durch die Hauptinduktivität des Impulsübertragers 10 im Regelfall um Größenordnungen kleiner sind als die Stromstärke des lmpulssignals, ändert sich die Form des Ausgangssignals (siehe Figur 4) hierdurch nur sehr geringfügig. Ein weiterer Vorteil dieser Anordnung eines Teiles des Abschlusswiderstandes 26 auf die Primärseite 12 des Impulsübertragers 10 ist die Reduktion der Spannung am Impulsübertrager 10, und damit der Kernverluste des Übertragerkernes 16 bei gleichzeitiger Erhöhung des Abstandes zur Sättigungsgrenze des Übertragerkernes 16.

Durch die erfindungsgemäße Ausbildung der zuletzt genannten Art kann ein und derselbe Impulsübertrager 10 sowohl als Hinkanal als auch als Rückkanal verwendet werden, wenn der Abschlusswiderstand 26 einfach durch einen zweiten Sender ersetzt wird.

### Bezugsziffernliste:

- 10: Impulsübertrager
- 12: Primärseite (von 10)
- 14: Sekundärseite (von 10)
- 16: Übertragerkern (von 10 für 12 und 14)
- 18: Impulskondensator (an 12)
- 20: Dämpfungswiderstand (an 14)
- 22: Impuls
- 24: Überschwinger
- 26: Abschlusswiderstand (an 14)
- 28: Schutzwiderstände (an 12)

## Patentansprüche

1. Verfahren zur Impulsübertragung, insbesondere zur Datenübertragung zwischen einer galvanisch getrennten Primär- und der Sekundärseite (12 und 14) über einen Impulsübertrager (10),
**dadurch gekennzeichnet,**
**dass** die Wicklung der Primärseite (12) des Impulsübertragers (10), je nach der Richtung der zu übertragenden Impulse, hart auf eine positive oder negative Spannung angehoben wird, was sich auf die Sekundärseite (14) entsprechend überträgt, und dass nach der gewünschten Impulsdauer die Primärseite (12) hart kurzgeschlossen wird.

2. Schaltungsanordnung mit einem Impulsübertrager (10) zur Durchführung des Verfahrens nach Anspruch 1,
**dadurch gekennzeichnet,**
**dass** an der Primärseite (12) des Impulsübertragers (10) ein Sender zur Erzeugung positiver und/oder negativer Spannungsimpulse und mindestens ein Ohmscher Widerstand (28) vorgesehen sind.

3. Schaltungsanordnung nach Anspruch 2,
**dadurch gekennzeichnet,**
**dass** der Ohmsche Widerstand von zwei gleich großen Ohmschen Widerständen (28) gebildet ist.

4. Impulsübertrager nach Anspruch 2,
**dadurch gekennzeichnet,**
**dass** der Abschlusswiderstand (26) der Sekundärseite (14) des Impulsübertragers (10) durch einen zweiten Sender ersetzt ist.
